(19) Europäisches Patentamt / European Patent Office / Office européen des brevets

(11) **EP 2 478 320 B1**

(12) **FASCICULE DE BREVET EUROPEEN**

(45) Date de publication et mention de la délivrance du brevet:
**29.04.2015 Bulletin 2015/18**

(21) Numéro de dépôt: **10751683.3**

(22) Date de dépôt: **13.09.2010**

(51) Int Cl.:
**F28F 13/16** *(2006.01)*    **F28F 13/18** *(2006.01)*

(86) Numéro de dépôt international:
**PCT/EP2010/063337**

(87) Numéro de publication internationale:
**WO 2011/029917 (17.03.2011 Gazette 2011/11)**

(54) **DISPOSITIF D'ECHANGE THERMIQUE A EFFICACITE AMELIOREE**

VERBESSERTE WÄRMEAUSTAUSCHVORRICHTUNG

IMPROVED HEAT EXCHANGE APPARATUS

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **14.09.2009 FR 0956308**

(43) Date de publication de la demande:
**25.07.2012 Bulletin 2012/30**

(73) Titulaire: **Commissariat à l'Énergie Atomique et aux Énergies Alternatives 75015 Paris (FR)**

(72) Inventeurs:
• **GAVILLET, Jérôme**
  **F-38120 Saint-egreve (FR)**
• **PHAN, Hai Trieu**
  **F-38000 Grenoble (FR)**

(74) Mandataire: **Ilgart, Jean-Christophe et al BREVALEX 95, rue d'Amsterdam 75378 Paris Cedex 8 (FR)**

(56) Documents cités:
EP-A2- 1 318 371    WO-A1-2006/016293
US-A1- 2005 167 820    US-A1- 2007 023 292
US-A1- 2008 047 701    US-A1- 2009 034 194

## Description

**DOMAINE TECHNIQUE ET ART ANTERIEUR**

La présente invention se rapporte à un procédé pour réaliser des échanges par ébullition selon les revendications 1 à 6, à un dispositif d'échange thermique par ébullition selon les revendications 7 à 27, et à un procédé de réalisation d'un tel dispositif selon les revendications 28 à 31.

Le document US 2008/0047701A1 divulgue un procédé et un dispositif pour réaliser des échanges thermiques d'un liquide polaire sur une surface présentant au moins une zone peu mouillante, consistant à modifier la mouillabilité de ladite surface par au moins un système d'électromouillage comportant au moins une électrode associée à une contre-électrode pour déplacer des goutelettes afin de modifier les échanges thermiques.

Le phénomène d'ébullition est très souvent utilisé dans les dispositifs d'échange thermique, ce phénomène peut suivre l'un ou l'autre des deux régimes suivants :

- l'ébullition en vase, dans ce régime la surface, de laquelle la chaleur est à évacuée, est immergée dans un liquide stagnant et non confiné, le phénomène dominant de l'ébullition en vase est l'ébullition nucléée.
- l'ébullition convective et confinée, dans ce régime le liquide s'écoule dans une conduite de diamètre hydraulique inférieur à la longueur capillaire dudit liquide.

Dans le cas de l'ébullition en vase, au-delà d'un flux de chaleur dit « critique », on observe l'apparition d'une couche continue de vapeur qui empêche tout contact entre le liquide et la paroi.

Les transferts de chaleur sont alors considérablement réduits.

La température de la paroi augmente alors continuellement, puisque la chaleur n'est quasiment plus évacuée.

Un point chaud est ainsi créé, pouvant entraîner la destruction du vase et de l'élément à refroidir.

Dans le cas de l'ébullition convective confinée dans un canal, les bulles sont en générale formées dans les zones proches de l'entrée du canal.

Puis, par effet de confinement, elles sont écrasées et coalescent pour former des bouchons de vapeur.

La chaleur est alors principalement transmise à travers une microcouche de liquide qui est en contact avec la paroi du canal.

On observe généralement, lors de transfert thermique dans les espaces confinés, un assèchement prématuré des parois du canal.

Cet assèchement provoque une diminution importante du coefficient d'échange thermique et donc une diminution des performances de l'élément à refroidir.

Par ailleurs, il a été montré que plus les surfaces sont mouillantes plus le flux de chaleur critique augmente.

Cependant, plus la mouillabilité d'une surface est augmentée, plus l'énergie requise pour former les premiers germes de vapeur est élevée.

La fréquence de formation de bulles de vapeur se trouve alors réduite.

C'est par conséquent un but de la présente invention d'offrir une surface d'échange thermique offrant à la fois les avantages d'une surface mouillante tout en ayant une fréquence de génération de bulles de vapeur suffisante.

**EXPOSÉ DE L'INVENTION**

Le but précédemment énoncé est atteint par une surface d'échange thermique faiblement mouillante intégrant des moyens électrique aptes à modifier les propriétés de mouillabilité de ladite surface, et à la rendre hydrophile sur demande.

Pour modifier les propriétés de mouillabilité de la surface, on utilise le principe de l'électromouillage en imposant à la surface après formation des bulles de vapeur, un potentiel augmentant la mouillabilité de la surface au niveau de la zone de formation des bulles de vapeur, facilitant le détachement des bulles de vapeur.

Dans un premier temps, on dispose d'une surface peu mouillante favorisant la génération de germes de vapeur, et dans un deuxième temps d'une surface mouillante favorisant le détachement des bulles de gaz.

En d'autres termes, on utilise une surface active dont la mouillabilité est modifiable sur commande, ce qui permet avantageusement d'associer dans le temps les avantages de la faible mouillabilité et ceux de la bonne mouillabilité.

Grâce à la mise en oeuvre de l'électromouillage, on peut modifier localement les propriétés de mouillabilité de la surface et ainsi générer des bulles de manière discrète et localisée.

Cette localisation permet d'éviter un afflux de bulles dans une zone et leur coalescence, pouvant créer un film de vapeur.

Selon l'invention, on module l'énergie de surface des parois en contact avec le liquide par actuation électrique, ce qui permet une amélioration du coefficient de transfert de chaleur et un retard dans l'apparition des phénomènes thermiques indésirables, i.e. l'apparition du flux de chaleur critique en ébullition en vase et un assèchement en ébullition convective.

De manière particulièrement avantageusement, la fréquence d'activation des moyens d'électromouillage est en phase avec la dynamique de formation des germes de vapeur et leur détachement de la paroi. La génération de bulles est alors optimale, ce qui a pour effet d'améliorer le transfert de chaleur et donc le refroidissement de l'élément chaud.

Dans un mode de réalisation applicable au régime d'ébullition en vase, on prévoit d'organiser de manière donnée les zones à mouillabilité variable et leur changement de mouillabilité, pour répartir la génération de bulles et leur détachement de manière synchronisée dans le temps et homogène dans l'espace et éviter une coalescence des bulles de vapeur.

Les risques d'apparition d'un flux de chaleur critique sont alors réduits.

De manière préférentielle, on dispose de plusieurs systèmes d'électromouillage répartis sous la surface, ceux-ci étant tous commandés simultanément, de sorte à provoquer simultanément le changement de mouillabilité de la surface les recouvrant. Le dispositif est alors simplifié.

Dans un autre mode de réalisation adapté au régime d'ébullition convective pour lequel le fluide s'écoule dans un canal, la zone de mouillabilité variable par électromouillage couplée à une source de chaleur est située à l'entrée du canal, pour générer des germes de vapeur qui vont croître sous forme de bulles dans le canal sous l'effet de la chaleur apportée par l'élément à refroidir. On maîtrise donc les instants auxquels des germes apparaissent en créant un générateur externe à la zone dans laquelle habituellement les germes apparaissent spontanément.

Ces germes peuvent être générés de manière suffisamment espacée dans le temps pour empêcher une coalescence des bulles de vapeur et l'apparition de bouchons de vapeur.

Le transfert thermique en est alors amélioré et l'assèchement des parois est retardé.

La présente invention a alors principalement pour objet un procédé pour réaliser des échanges thermiques par ébullition d'un liquide polaire sur une surface présentant au moins une zone peu mouillante, consistant à :

> a) générer l'apparition de germes de vapeur sur ladite zone peu mouillante et faire croître lesdits germes,
> b) rendre ladite surface mouillante par au moins un système d'électromouillage pour favoriser le détachement des dites bulles de gaz ainsi formées.

La surface peut être entièrement peu mouillante, et une pluralité de systèmes d'électromouillage est répartie sous cette surface, lors de l'étape b), les systèmes d'électromouillage sont tous activés simultanément pour favoriser le détachement des dites bulles de gaz formées.

La surface peut comporter plusieurs systèmes d'électromouillage au nombre de m répartis sous la surface et étant activables séparément, m étant égal à n + p, m, n et p étant des entiers naturels, les étapes a) et b) s'appliquant périodiquement aux n et aux p systèmes d'électromouillage, l'étape a) s'appliquant à n systèmes et l'étape b) à p systèmes simultanément, et l'étape a) s'appliquant simultanément aux p systèmes et l'étape b) au n systèmes simultanément.

La période d'activation des électrodes peut être avantageusement sensiblement égale à la somme de la période de génération des germes de vapeur et de la période de croissance des bulles de vapeur, par exemple comprise entre 10 Hz et 100 Hz.

Dans un autre exemple, la surface peut comporter une électrode sous forme d'une piste courant sous la surface, ladite surface comportant au dessus de l'électrode une alternance de zones peu mouillantes et de zones mouillantes, les étapes a) et b) s'appliquant à l'électrode unique.

L'ébullition peut être convective et confinée, la surface formant alors une portion d'un conduit dans lequel s'écoule le liquide polaire, ladite surface étant localisée en amont de la zone où à lieu l'échange thermique, la surface comporte des moyens de chauffage, lors de l'étape a), un apport de chaleur est effectué au liquide polaire au niveau de la surface.

La présente invention a également pour objet un dispositif d'échange thermique comportant une surface en contact avec un liquide polaire et destinée à extraire de la chaleur d'un élément, ladite surface comportant au moins un système apte à modifier localement la mouillabilité de la surface en contact avec le liquide polaire par électromouillage, ledit système comportant au moins une électrode associée à une contre-électrode et des moyens de commande pour activer une électrode par application d'un potentiel à ladite électrode, la surface de la paroi ayant, au moins partiellement, en l'absence de potentiel appliqué à ladite électrode des propriétés de faible mouillabilité, ledit système étant isolé du liquide par une couche diélectrique.

Par exemple, le liquide polaire s'écoule, ledit système d'électromouillage étant situé dans une partie de la paroi en amont de la partie en contact avec l'élément à refroidir, ledit dispositif comportant également des moyens pour faire circuler le liquide dans le conduit et des moyens de chauffage situés au niveau du système d'électromouillage.

Le système d'électromouillage peut comporter au moins une électrode associée à une contre-électrode réparties transversalement par rapport à l'écoulement du liquide.

La au moins une électrode a par exemple une forme d'anneau et la contre-électrode est située au centre dudit anneau. Le diamètre extérieur de l'électrode est par exemple compris entre 0,1 mm et 1 mm et le diamètre de la contre-électrode est compris entre 1 $\mu$m et 10 $\mu$m, la distance entre l'électrode et la contre-électrode étant par exemple comprise entre 1 $\mu$m et 50 $\mu$m.

La distance entre deux électrodes adjacentes peut être comprise entre 0,1 mm et 1 mm.

Les moyens de chauffage peuvent être formés par une résistance électrique en forme d'anneau entourée par l'électrode et entourant la contre-électrode.

Dans un autre exemple de réalisation, le système d'électromouillage comporte une électrode sous forme de peigne comportant un corps et des doigts transversaux au corps, lesdits doigts étant orientés sensiblement dans la direction d'écoulement du liquide polaire, et une contre-électrode en forme de peigne, les doigts de la contre-électrode étant interdigités avec ceux de l'électrode, la surface comportant également des zones mouillantes alternant avec des zones peu mouillantes le long des doigts, les moyens de chauffage cheminant entre les doigts de l'électrode et ceux de la contre-électrode.

Les zones mouillantes et les zones peu mouillantes sont, par exemple sous la forme de bandes sensiblement perpendiculaires à la direction d'écoulement du liquide polaire et s'étendent sur toute la longueur du peigne.

Dans un autre mode de réalisation, l'ébullition peut être en vase, ladite surface formant le fond dudit dispositif, le système d'électromouillage comportant une pluralité d'électrodes associées à au moins une contre-électrode, lesdites électrodes étant réparties sur toute la surface de la paroi.

Dans un exemple de réalisation particulièrement avantageux, les moyens de commande activent et désactivent simultanément toutes les électrodes périodiquement.

Dans un autre exemple de réalisation, les moyens de commande activent et désactivent les électrodes par groupe ou séparément périodiquement de manière déphasée.

Par exemple, les électrodes sont réparties en damier.

Toute la surface peut être peu mouillante, ou les zones au dessus des électrodes sont peu mouillantes et les zones entre les zones au dessus des électrodes sont mouillantes. Par exemple, les zones mouillantes ont la forme d'un quadrillage.

Dans une variante de réalisation d'un dispositif avec ébullition est en vase, la surface peut former le fond dudit dispositif, le système d'électromouillage comportant une électrode sous forme de piste courant sous la surface de la paroi, et une contre-électrode sous forme de piste cheminant à côté de l'électrode.

Les surfaces au dessus des pistes sont par exemple divisées en zone de faible mouillabilité par des zones de bonne mouillabilité.

On peut prévoir de configurer l'électrode et la contre-électrode sous forme de spirale.

La surface au dessus des électrodes par exemple comportent des premières bandes offrant des propriétés de bonne mouillabilité et des deuxièmes bandes offrant des propriétés de faible mouillabilité, lesdites premières et deuxièmes bandes étant alternées et croisant les différentes portions de l'électrode (108).

Dans une variante de réalisation, l'électrode et la contre-électrode ont la forme de peignes interdigités, la surface comportant des zones mouillantes et des zones peu mouillantes au dessus de l'électrode. Par exemple, les zones mouillantes et peu mouillantes sont formées par des bandes mouillantes et peu mouillantes croisant les doigts des peignes.

Par exemple, le liquide polaire est l'eau ou un éthylène glycol.

La présente invention a également pour objet un procédé de réalisation d'un dispositif d'échange thermique selon la présente invention, comportant les étapes :

a) dépôt d'une première couche isolante électrique sur un substrat,
b) dépôt d'une couche conductrice électrique sur ladite couche isolante électrique pour former des électrodes,
c) dépôt d'une deuxième couche isolante électrique sur la couche conductrice électrique,
d) dépôt sur la deuxième couche isolante électrique d'un film offrant des propriétés de faible mouillabilité.

Le procédé de réalisation d'un dispositif d'échange thermique peut comporter l'étape ultérieure e) de réalisation dans le film de zones ayant de propriétés de bonne mouillabilité. L'étape e) est par exemple obtenue par oxydation du film offrant des propriétés de faible mouillabilité (308) au moyen d'un laser.

Le procédé peut également comporter l'étape de gravure de la couche conductrice électrique.

Le substrat est par exemple en acier, le première couche isolante électrique est en SiC/SiO$_2$, et la couche de faible mouillabilité est par exemple en SiOC.

**BRÈVE DESCRIPTION DES DESSINS**

La présente invention sera mieux comprise à l'aide de la description qui va suivre et des dessins sur lesquels :

- la figure 1A est une vue de dessus schématique d'un exemple de réalisation d'une surface d'échange thermique selon un premier mode de réalisation de la présente invention,
- la figure 1B est une vue de dessus schématique d'une variante de la surface d'échange thermique de la figure 1A,
- la figure 2 est une vue de dessus d'une variante de réalisation d'une surface d'échange thermique selon un premier mode de réalisation de la présente invention,
- la figure 3 est une vue de dessus d'une autre variante de réalisation d'une surface d'échange thermique selon un premier mode de réalisation de la présente invention,
- la figure 4A est une représentation schématique vue de côté d'une surface d'échange thermique selon un autre mode de réalisation,
- la figure 4B est une vue de dessus d'un détail de la figure 4A,
- la figure 4C est une vue de dessus d'une variante de réalisation du détail de la figure 4A,

- la figure 5 est une vue de dessus d'un autre exemple de réalisation de l'autre mode de réalisation,
- les figures 6A à 6D sont des représentations schématiques des différentes étapes d'un exemple d'un procédé de réalisation d'un dispositif selon la présente invention,
- les figures 7A et 7B sont des schémas explicatifs d'une surface mouillante et faiblement mouillante,
- les figures 8A et 8B sont des représentations graphiques de l'évolution de la mouillabilité de deux surfaces en fonction de la tension appliquée.

## EXPOSÉ DÉTAILLÉ DE MODES DE RÉALISATION PARTICULIERS

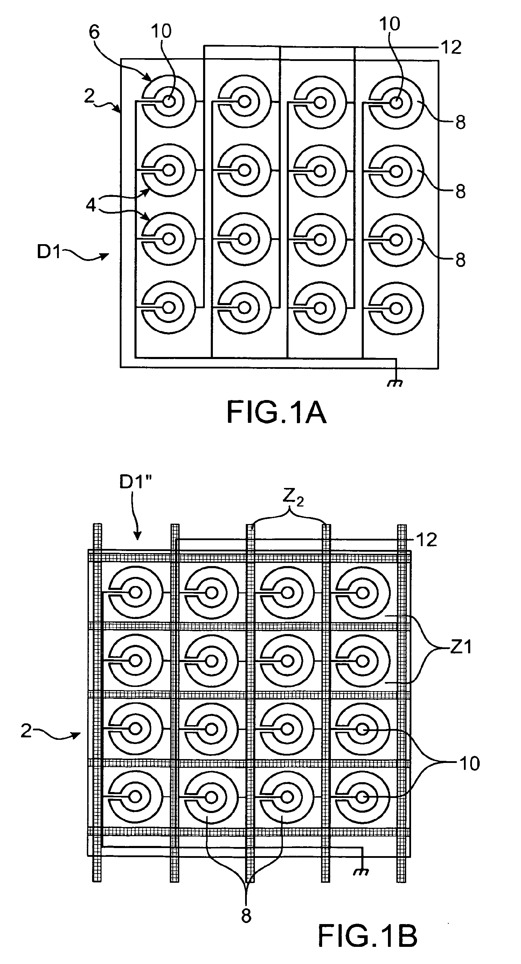

Sur la figure 1A, on peut voir un premier exemple d'un dispositif d'échange thermique D1 selon la présente invention adapté au régime d'ébullition en vase.

Le dispositif D1 comporte une surface d'échange thermique 2 destinée à être recouverte d'un liquide polaire (non représenté).

La surface d'échange thermique est destinée à être en contact avec un élément à refroidir (non visible) par sa face opposée à celle en contact avec le liquide polaire.

La surface d'échange thermique 2 présente au moins dans des zones localisées 4 des propriétés de faible mouillabilité vis-à-vis du fluide polaire.

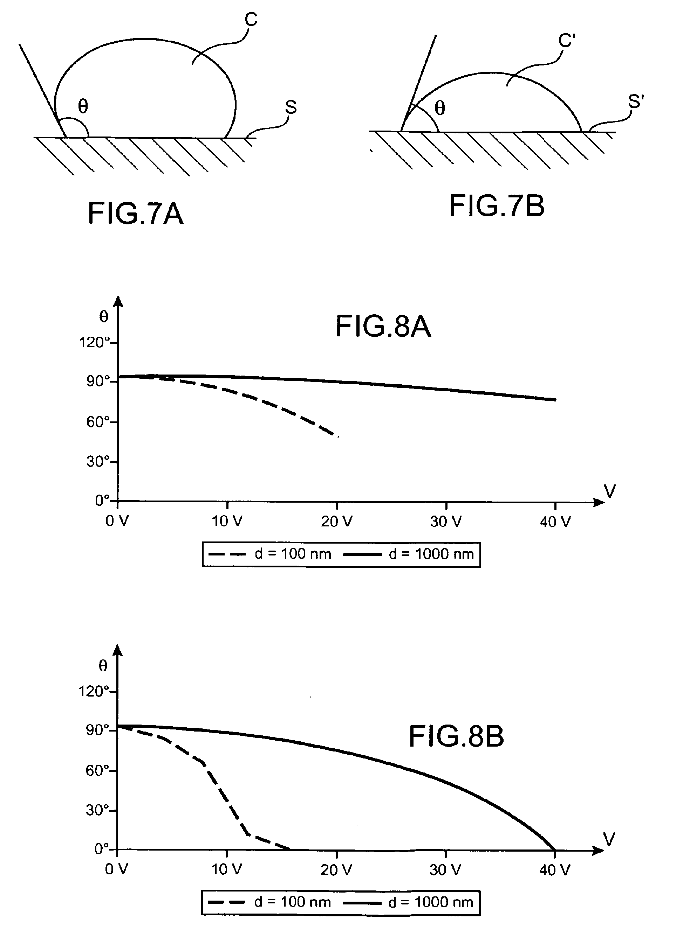

Une surface présente des propriétés de faible mouillabilité vis-à vis d'un liquide, lorsque l'angle de contact θ est supérieur à 90°, tel que représenté sur la figure 7A. Une surface offre des propriétés de bonne mouillabilité vis-à vis d'un liquide, lorsque l'angle de contact θ est inférieur à 90°, tel que représenté sur la figure 7B.

Dans le cas de l'eau, on parle de surface hydrophobe pour une surface faiblement mouillante, et de surface hydrophile pour une surface mouillante.

En outre, selon l'invention le dispositif comporte un système d'électromouillage 6 afin de moduler temporellement l'angle de contact entre le liquide et la surface d'échange thermique de manière locale.

La modification de la tension électrique modifie les propriétés de mouillabilité de la surface 2 vis-à-vis du fluide polaire.

Dans le présent exemple, le système est apte à transformer temporairement une surface hydrophobe en une surface hydrophile.

Dans l'exemple représenté, le système d'électromouillage comporte une pluralité d'électrodes 8 reparties dans le plan de la surface d'échange thermique.

Dans l'exemple représenté, la répartition est sous forme de lignes et de colonnes, mais cette disposition n'est en aucun cas limitative.

Chaque électrode 8 est associée à une contre-électrode 10.

Dans l'exemple représenté, les électrodes 8 ont une forme annulaire connectée à une source de tension 12 et une contre-électrode 10 est disposée au centre de chacune des électrodes 8, les contre-électrodes 10 sont dans l'exemple représenté, connectées à la terre.

Les électrodes 8 et contre-électrodes 10 sont recouvertes d'une couche diélectrique (non représentée), séparant le fluide des électrodes 8 et contre-électrodes 10.

En outre, la surface d'échange thermique présente au moins des zones hydrophobes vis-à-vis du liquide polaire.

Dans cet exemple de réalisation, toute la surface présente cette propriété.

En outre, le système comporte des moyens de commande (non représentés) pour appliquer une tension entre chaque électrode 8 et contre-électrode 10 associée. Seule l'alimentation électrique est représentée.

Les moyens de commande peuvent donc appliquer une tension aux couples d'électrode/contre-électrode.

Le mouillage d'un liquide varie selon une loi décrite par l'équation de Lippman-Young's :

$$\cos\theta = \cos\theta_Y + \frac{\varepsilon\varepsilon_0}{2\gamma d}V^2$$

dans laquelle θ est l'angle de contact au potentiel V, θ$_Y$ l'angle de contact au potentiel 0 V, Y l'énergie de surface du liquide, ε$_0$ la permittivité du vite, ε la constante diélectrique de la couche isolante et d l'épaisseur de cette couche isolante.

Ainsi, lorsque l'on applique un potentiel V, la valeur de cosθ augmente.

L'angle θ est donc inférieur à l'angle θ$_γ$. Avec une valeur de V suffisante, θ devient inférieur à 90° rendant la surface hydrophile.

L'électromouillage permet de, moduler localement l'angle de contact du fluide.

Dans le cas de l'eau, l'angle de contact peut varier entre 60° et 110°.

Sur la figure 8B, on peut voir l'évolution de la mouillabilité de l'éthylène glycol sur une couche isolante de constante diélectrique égale à 8 recouverte d'un film hydrophobe dont l'angle de contact est égal à 95°.

L'évolution de l'angle de contact θ en fonction de la tension appliquée à l'électrode est représentée pour une épaisseur de couche isolante de 100 nm et une épaisseur de couche isolante de 1000 nm.

On constate que, par rapport à une couche isolante de constante diélectrique égale à 2 (représentée sur la figure 8A), l'angle de contact θ diminue plus rapidement, pour être nul pour une couche isolante de 100 nm lorsque la tension est supérieure à 15 V, pour une couche isolante d'épaisseur 1000 nm lorsque la tension est égale ou supérieure à 40 V.

A des fins de simplicité, nous considérerons le cas de l'eau comme fluide polaire.

Cependant, il est bien entendu que tout autre liquide polaire, comme fluide d'ébullition diphasique, peut être utilisé, comme par exemple l'éthylène glycol mentionné ci-dessus.

Dans la suite de la description, on désignera par activation, l'application d'un potentiel à une électrode.

Selon un premier exemple de réalisation particulièrement avantageux de la présente invention, l'activation des électrodes est effectuée collectivement de manière à ce que toutes les électrodes de la zone non mouillante soient activées simultanément.

En contrôlant la fréquence d'activation des électrodes et en choisissant une distance entre électrodes adaptée, la taille des germes et donc des bulles de vapeur est contrôlée, évitant ainsi un risque de coalescence.

La période de germination et de croissance, lors de laquelle les électrodes ne sont pas activées, est relativement plus longue que la période de décrochage des bulles, lors de laquelle les électrodes sont activées. Cet exemple de réalisation permet d'enchaîner rapidement la création d'un grand nombre de bulles sur toute la surface d'échange thermique, rendant plus efficace l'évacuation de la chaleur.

Les électrodes sont disposées les unes par rapport aux autres de manière suffisamment espacée pour éviter que, lors de la croissance des bulles de vapeur, les bulles ne viennent au contact les unes des autres et coalescent pour former une nappe de vapeur.

Selon un second exemple de réalisation, les électrodes adjacentes sont activées de manière décalée dans le temps.

Cette activation décalée dans le temps permet d'éviter que des bulles de vapeur trop proches coalescent et forment une nappe de vapeur, et permet d'optimiser l'utilisation de la surface effective générant des bulles de vapeur.

En outre, de manière également très avantageuse, la période d'activation des électrodes est sensiblement égale à la somme de la période de génération des germes de vapeur et de la période de croissance des bulles de vapeur.

La fréquence correspondante est comprise entre 10 Hz et 100 Hz.

Le temps entre l'activation de deux électrodes adjacentes correspond donc au temps nécessaire à la germination d'une bulle de vapeur et à sa croissance. Ainsi le rendement dans la production de bulles de vapeur et donc dans l'évacuation de la chaleur est optimisé.

La surface d'échange thermique peut soit être entièrement hydrophobe à l'état naturel, i.e. sans application de tension aux électrodes 8, soit être uniquement hydrophobe au dessus des électrodes 8.

Selon le premier exemple de réalisation, les électrodes sont toutes collectivement reliées à une source de tension.

Le système est alors simplifié au niveau de la réalisation du dispositif et au niveau de la commande.

Selon le deuxième exemple de réalisation, les électrodes 8 peuvent être commandées individuellement, dans ce cas, chaque électrode 8 est reliée à une source de tension de manière individuelle.

De préférence c, les électrodes sont réparties en deux groupes sous forme d'un damier, en fonction de leur localisation, les deux groupes s'enchevêtrant, chaque électrode d'un groupe n'étant entourée que d'électrodes de l'autre groupe.

Les deux groupes sont alors activés alternativement, avantageusement avec la fréquence mentionnée ci-dessus.

Nous allons maintenant expliquer un exemple de fonctionnement du dispositif de la figure 1 dans le refroidissement de l'élément à refroidir selon le premier exemple de réalisation.

Aucune des électrodes n'est activée, la surface située au dessus des électrodes est donc hydrophobe, ce qui a pour conséquence de faciliter l'apparition de germes de vapeur.

Les germes croissent sous l'effet de la chaleur apportée par l'élément.

La surface d'échange thermique est donc le lieu d'apparitions d'une multitude de germes de vapeur répartis de manière discrète sur toute la surface.

Les germes de vapeur grossissent et forment des bulles de vapeur.

Avantageusement, la période de croissance est telle que la taille des bulles évite une coalescence entre les bulles.

Lorsque les bulles de vapeur ont suffisamment grossi, les électrodes 8 sont activées, la surface au dessus des électrodes 8 passe dans un état hydrophile, ce qui favorise le détachement des bulles de vapeur.

Par conséquent, toutes les bulles de vapeur se détachent.

Les électrodes passent alors de nouveau dans un état désactivé, la surface les recouvrant est de nouveau le siège de germinations.

Cette succession de commande se poursuit tant qu'une évacuation de chaleur est requise.

Les activations peuvent être effectuées selon une fréquence comprise entre 10 Hz et 100Hz.

Selon le deuxième exemple de réalisation, on prévoit d'activer alternativement les deux groupes d'électrodes, seule une partie de la surface étant le siège de germination de bulles.

Les électrodes des deux groupes peuvent être disposées de sorte qu'une électrode non activée soit entourée d'électrodes activées, évitant ainsi l'apparition d'une nappe de vapeur.

La surface d'échange thermique est donc le siège d'apparitions organisées de bulles de vapeur localisées et avantageusement séparées les unes des autres, limitant ainsi les risques de coalescence et d'apparition de nappe de vapeur.

Sur la figure 1B, on peut voir une variante de réalisation particulièrement avantageuse d'un dispositif d'échange thermique D1' selon la premier mode de réalisation, qui diffère du dispositif de la figure 1A, en ce que les zones situées entre les zones au dessus des électrodes sont hydrophiles.

La surface comporte des zones Z1 ayant naturellement des propriétés hydrophobes situées au dessus des électrodes, et des zones Z2 ayant naturellement des propriétés hydrophiles entre les zones hydrophobes Z1.

Dans l'exemple représenté, les zones hydrophiles Z2 forment un quadrillage dont les cases sont hydrophobes. Ainsi, lors de la germination, les bulles sont circonscrites aux zones hydrophobes, ce qui évite la formation d'une nappe de vapeur généralisée. Ensuite, lors de l'activation des électrodes, les zones Z1 deviennent hydrophiles et favorisent avec les zones Z2 le décrochement des bulles.

Dans cette variante, toutes les électrodes 8 peuvent être activées simultanément, puisque les zones au dessus de deux électrodes adjacentes sont séparées par une zone hydrophile, la coalescence de deux bulles voisines est évitée.

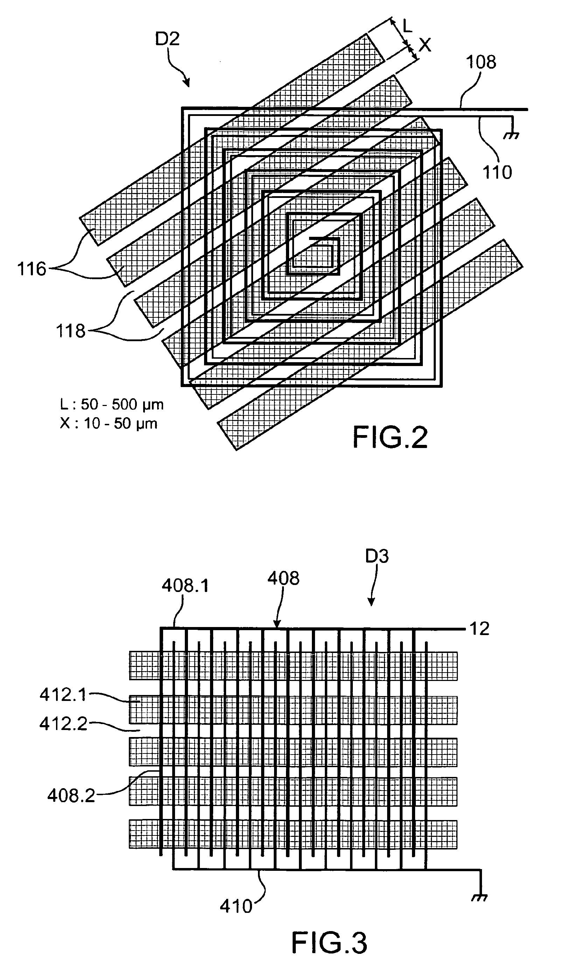

Sur la figure 2, on peut voir une autre variante de réalisation particulièrement avantageuse d'un dispositif d'échange thermique D2.

Dans cet exemple de réalisation, le dispositif D2 comporte une électrode 108 sous forme de piste reliée à une source de tension 12 et une contre-électrode 110 reliée à la terre, l'électrode et la contre-électrode sont parallèles et courent sous toute la surface.

Dans l'exemple représenté, l'électrode 108 et la contre-électrode 110 sont configurées sous la forme d'une spirale carrée.

Il est bien entendu qu'une spirale circulaire ou de toute autre forme est utilisable.

En outre, on discrétise les zones de génération de bulles sur la piste afin d'éviter les risques d'apparition de lignes de vapeur. On réalise pour cela une surface partiellement hydrophile.

Dans l'exemple représenté, la surface comporte des bandes hydrophiles 116 alternant avec des bandes hydrophobes 118, inclinées par rapport à la piste.

Dans l'exemple représenté, les bandes croisent la piste d'électrode à 45°. Ainsi, la surface comporte au dessus de l'électrode 108 des zones hydrophobes alternant avec des zones hydrophiles.

Ainsi, l'apparition des bulles est favorisée sur les zones hydrophobes, qui sont entourées de zones hydrophiles. On évite les risques d'apparition d'une ligne de vapeur le long de l'électrode.

Les dimensions des pistes et leur espacement sont choisis en fonction de la taille des bulles.

Par exemple, la largeur de la piste est supérieure ou égale à la taille critique d'un germe de vapeur, soit comprise entre 10 et 100 $\mu$m.

L'espacement des pistes est compris entre 0,1 et 2 mm.

Des bulles de vapeur sont donc distribuées le long de la piste et dessinent de manière discrète une spirale.

La piste s'étendant sur toute la surface du dispositif, une ébullition répartie sur toute la surface est alors obtenue.

La largeur L des bandes hydrophiles est avantageusement comprise entre 50 $\mu$m et 500 $\mu$m, et la largeur X des bandes hydrophobes sont comprise entre 10 $\mu$m et 50 $\mu$m.

Les bandes sont obtenues par exemple, en réalisant un traitement hydrophobe, puis en formant les bandes hydrophiles par oxydation au moyen d'un laser ou d'une exposition à l'air sous UV.

La forme en spirale carrée ou rectangulaire permet de couvrir de manière homogène le fond d'un récipient à fond carré ou rectangulaire respectivement.

On pourrait également envisager de réaliser des pistes sous la forme de zigzag.

Sur la figure 3, on peut voir une variante D3 du dispositif de la figure 2.

Le dispositif D3 comporte une électrode 408 ayant la forme d'un peigne muni d'une base 408.1 et de doigts 408.2 s'étendant transversalement par rapport à la base 408.1.

L'électrode 408 est raccordée à une source de tension 12 au niveau de sa base 408.1.

Le dispositif D3 comporte également une contre-électrode 410 en forme de peigne, les deux peignes étant interdigités. Ainsi, les doigts 408.2 de l'électrode 408 alternent avec les doigts de la contre-électrode 410.

En outre, la couche diélectrique recouvrant les électrodes est recouverte d'une couche munie de bandes alternées 412.1, 412.2 présentant pour les unes 412.1 une bonne mouillabilité et pour les autres 412.2 une faible mouillabilité, ces bandes 412.1, 412.2 étant orthogonales aux doigts des peignes.

Par conséquent, chaque surface au dessus de chaque électrode en ligne présente des zones activables avec des zones non activables alternées.

Le fonctionnement de ce dispositif est similaire à celui de la figure 2. Une génération de germes apparaît le long des doigts 408.2 au niveau des intersections entre les bandes 412.2 et les doigts 408.2.

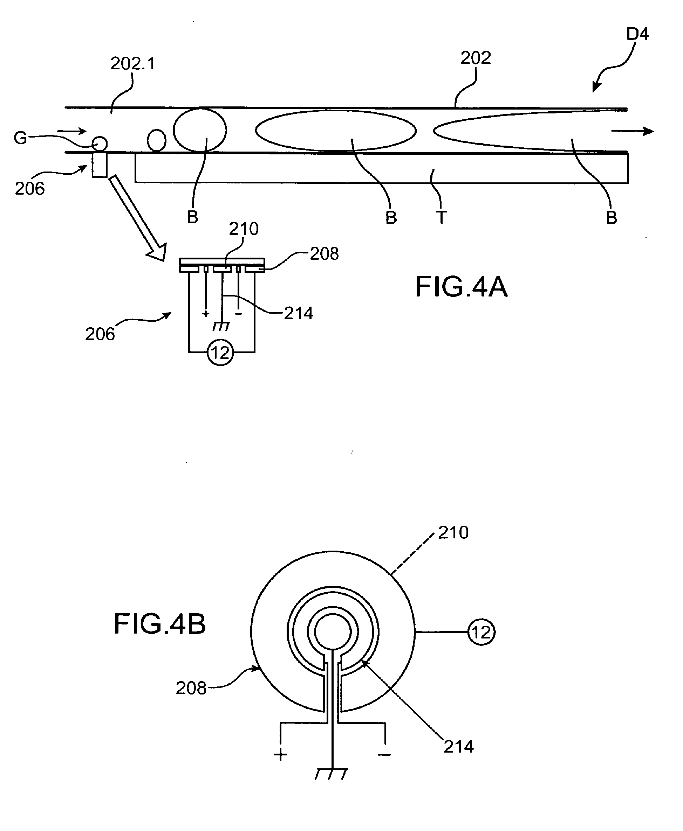

Sur la figure 4A, on peut voir un autre mode de réalisation d'un dispositif D4 d'échange thermique selon la présente invention.

Ce mode de réalisation utilise l'ébullition convective et confinée.

Le dispositif d'échange thermique D4 comporte un conduit 202 fermé de diamètre hydraulique inférieur à la longueur capillaire du fluide 4 utilisé pour extraire les calories.

Ce conduit 202 peut être en contact sur un côté avec l'élément à refroidir T ou être enfoui dans celui-ci.

Le dispositif comporte également des moyens (non représentés) pour faire circuler le fluide dans canal 202.

Le canal 202 comporte une portion d'extrémité en amont 202.1 de l'élément à refroidir. Le canal forme un circuit fermé avec les moyens de circulation, par exemple une pompe hydraulique, le fluide 4 au-delà de la portion en aval de l'élément est renvoyé vers la portion d'extrémité amont.

Selon la présente invention, le dispositif d'échange thermique comporte un système d'électromouillage 206 situé au niveau de la portion d'extrémité amont sous la surface du canal, et des moyens de chauffage 214.

La surface intérieure de la portion d'extrémité amont, au moins au niveau du système d'électromouillage 206 présente des propriétés hydrophobes.

La surface intérieure de la portion du conduit en contact avec l'élément à refroidir T présente avantageusement une surface hydrophile pour limiter l'apparition de germes de vapeur en dehors de la portion d'extrémité amont 202.1.

Sur la figure 4B, on peut voir une représentation schématique d'un exemple d'un système d'électromouillage 206 et des moyens de chauffage 214.

Le système d'électromouillage comporte une électrode annulaire 208 connectée à une source de tension 12 et une contre-électrode 210 au centre de l'électrode connectée à la terre.

Les moyens de chauffage 214 sont avantageusement disposés entre la contre-électrode 210 et l'électrode 208, pour localiser au maximum la zone de génération de germes de vapeur.

Par exemple, les moyens de chauffage sont formés par une résistance électrique en forme d'anneau connectée à une source de courant électrique.

Les moyens de chauffage sont par exemple électriques, électrodynamiques, ultrasoniques, piézoélectriques, laser.

La formation des bulles peut aussi être faite en utilisant un réservoir de vapeur.

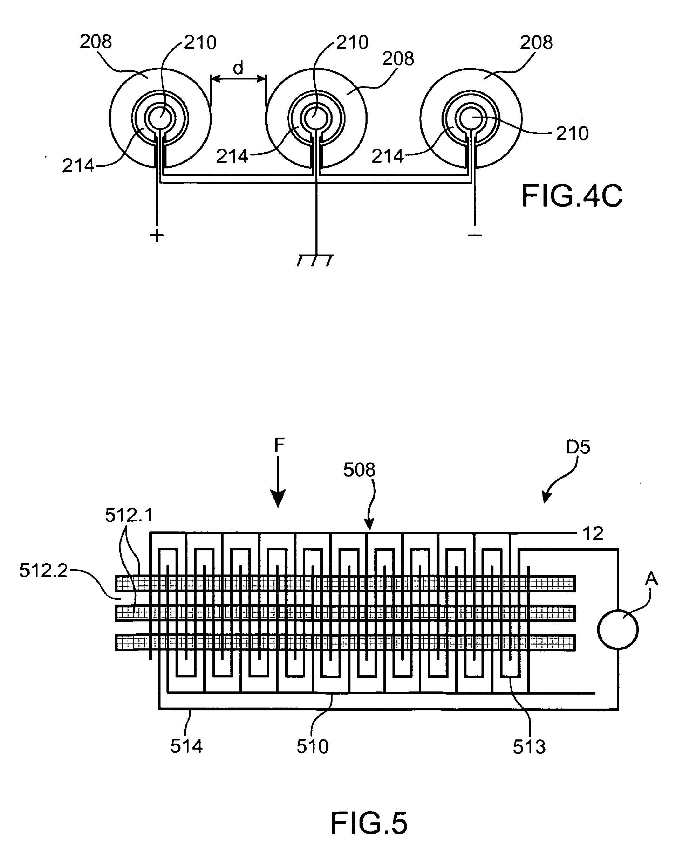

Sur la figure 4C, on peut voir, vu de dessus, un système d'électromouillage 206 comportant plusieurs couples d'électrode 208 - contre-électrode 210, chaque couple étant associé à des moyens de chauffage 214.

Ce système d'électromouillage 206 à plusieurs couples d'électrode / contre-électrode permet de couvrir toute la largeur du canal sur une ligne, comme on peut le voir sur la figure 4C sur laquelle trois ensembles sont juxtaposés.

Il n'est pas nécessaire d'avoir un déphasage dans l'activation des électrodes 208, on peut produire simultanément des bulles qui seront emportées par la circulation du fluide.

Les trois électrodes 208 peuvent être connectées en parallèle, et les trois moyens de chauffage peuvent être connectés en série.

Il est bien entendu que le dispositif D4 peut comporter plusieurs canaux, de diamètre par exemple inférieur à 3 mm et de longueur variable, par exemple, quelques cm, fonction de l'élément à refroidir.

Nous allons maintenant expliquer le fonctionnement du dispositif D4.

On cherche à extraire la chaleur de l'élément à refroidir. Le fluide circule dans le canal 202.

Les moyens de chauffage 214 sont activés, ils émettent de la chaleur dans la portion d'extrémité amont, favorisant la montée en température du fluide dans cette zone.

Cette source de chaleur apporte une énergie suffisante pour créer un germe critique G de vapeur dans des conditions de paroi hydrophobe.

Cette énergie est néanmoins insuffisante pour créer le même germe dans des conditions de paroi hydrophile.

Typiquement, le flux de chaleur considéré est de l'ordre de 1-50 kW/m$^2$.

La puissance de la source de chaleur n'a donc pas besoin d'être importante, et est en tout cas très inférieure à celle de la source de chaleur formée par l'élément à refroidir.

Ensuite, les germes de vapeur grossissent pour former des bulles de vapeur B.

L'électrode 208 est ensuite activée provoquant une modification de l'angle de contact du liquide entourant la bulle de vapeur, la zone devient alors hydrophile favorisant le détachement de la bulle.

La bulle B va ensuite cheminer dans la portion du canal en contact avec l'élément à refroidir, et grossir au fur et à mesure de son déplacement en provoquant la vaporisation du liquide autour d'elle, et extrayant des calories.

Ainsi la commutation de l'électrode est effectuée à une fréquence de l'ordre de 10-100 Hz correspond à la fréquence de germination et de croissance d'une bulle de vapeur.

A titre d'exemple, l'électrode 208 en forme d'anneau peut avoir un diamètre extérieur compris entre 0,1 mm et 2 mm.

La contre-électrode est circulaire de diamètre compris entre 1 $\mu$m et 10 $\mu$m. La distance entre l'électrode et la contre-électrode est comprise entre 10 $\mu$m et 50 $\mu$m.

Dans le cas où le dispositif d'électromouillage comporte plusieurs couples d'électrode et contre-électrode, ceux-ci sont par exemple séparés d'une distance comprise entre 0,1 mm et 1 mm.

Grâce à ce mode de réalisation, on contrôle la fréquence d'apparition des bulles et leur taille.

Ainsi, il est possible d'éviter que les bulles ne soient trop proches les unes des autres et coalescent, formant alors des bouchons de vapeur.

Sur la figure 5, on peut voir un autre exemple de réalisation d'un dispositif D5 selon le deuxième mode de réalisation, en mode d'ébullition convective et confinée.

L'écoulement du fluide est symbolisé par la flèche F.

Le dispositif d'échange thermique D5 comporte une électrode 508 sous forme de peigne connectée à une source de tension 12, et un une contre-électrode 510 également sous la forme d'une peigne reliée à la masse.

L'électrode 508 et la contre-électrode 510 sont interdigitées.

Les doigts de peignes sont orientés sensiblement dans la direction d'écoulement du fluide F.

En outre, le dispositif D5 comporte des moyens de chauffage 514 serpentant entre le doigt de l'électrode 508 et les doigts de la contre-électrode 510.

Dans l'exemple représenté, les moyens de chauffage 514 sont formés par une résistance électrique reliée à un générateur de courant électrique désigné A.

En outre, la couche diélectrique recouvrant les électrodes est recouverte d'une couche munie de bandes alternées 512.1, 512.2 présentant pour les unes 512.1 une bonne mouillabilité et pour les autres 512.2 une faible mouillabilité, ces bandes 512.1, 512.2 étant orthogonales aux doigts de l'électrode 508.

Par conséquent, chaque surface au dessus de chaque doigt présente des zones activables avec des zones non activables alternées.

Les germes de vapeur sont générés le long des doigts au niveau des intersections avec les zones hydrophobes.

Les bulles étant générées le long de lignes perpendiculaire à l'axe du canal. Ces bulles sont emportées par l'écoulement du fluide.

La présence de zones hydrophiles et hydrophobes alternées permet d'éviter la formation de bande de vapeur.

La présente invention permet d'augmenter le coefficient d'échange thermique en retardant la formation d'une phase vapeur au niveau de la paroi, qu'il s'agisse d'un dispositif fonctionnant en régime d'ébullition en vase ou en régime d'ébullition convective et confinée.

Nous allons maintenant décrire un procédé de réalisation de tels dispositifs d'échange thermique.

On utilise un substrat 300, par exemple en métal comme par exemple l'aluminium ou le cuivre, ou en alliage métallique ou en silicium.

De manière avantageuse, le substrat est en acier.

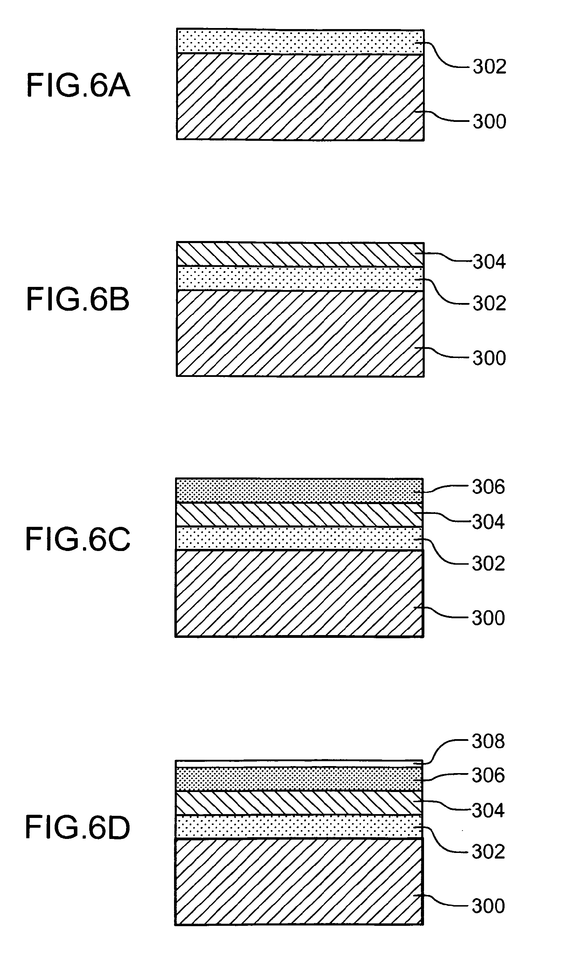

Lors d'une première étape représentée sur la figure 6A, on dépose une couche électriquement isolante 302 sur le substrat, cette couche est destinée à assurer une isolation électrique entre le substrat et la couche métallique servant pour la réalisation des électrodes.

Par exemple, la couche isolante électrique est constituée de SiC, de SiN, de $SiO_2$ ou d'une combinaison de ces matériaux.

De manière avantageuse, la couche 302 est en $SiC/SiO_2$, assurant une bonne adhésion sur le substrat d'un part et sur la couche conductrice qui formera les électrodes d'autre part.

L'épaisseur de la couche 302 est choisie suffisamment faible pour ne pas affecter notablement l'échange thermique entre l'élément à refroidir et le fluide.

Par exemple, l'épaisseur de $SiC/SiO_2$ est de l'ordre de 100 nm à 1000 nm pour une constante diélectrique $\varepsilon$ apparente de l'ordre de 2-8.

Le dépôt de cette couche peut être réalisé par un procédé conventionnel de dépôt sous vide de type PVD (dépôt physique en phase vapeur) ou CVD (dépôt chimique en phase vapeur).

Lors d'une étape suivante représentée sur la figure 6B, on dépose une couche conductrice électrique 304 sur la couche isolante électrique 302 sous la forme d'un film mince. La couche conductrice 304 est par exemple en cuivre, en or, en titane, en molybdène ou en un autre matériau ou alliage conducteur.

Son épaisseur est par exemple comprise entre 100 nm à 1000 nm.

Le dépôt de cette couche peut être réalisé par un procédé conventionnel de dépôt sous vide de type PVD.

Lors d'une étape suivante (non représentée), on structure les électrodes. Par exemple, on peut effectuer cette structuration au moyen d'un masque physique déposé sur la couche 304.

La partie apparente de la couche 304 est ensuite gravée et le masque retiré.

On peut aussi prévoir de réaliser cette structuration par procédé lift-off, i.e. on dépose le masque en résine photosensible avant de déposer la couche conductrice 304, le masque étant un négatif de la structure souhaitée pour les électrodes.

Puis, la couche conductrice 304 est déposée sur le masque.

Le masque est ensuite supprimé par exemple au moyen d'un solvant, emportant les zones de la couche 304 déposées sur le masque.

Lors d'une étape suivante représentée sur la figure 6C, on dépose une seconde couche électriquement isolante 306 sur les électrodes.

Celle-ci est similaire à la première couche 302.

Elle peut être faite du même matériau ou d'un matériau différent.

Son épaisseur est par exemple comprise entre 100 nm et 1000 nm pour une constante diélectrique $\varepsilon$ apparente de l'ordre de 2-8.

Lors d'une étape suivante représentée sur la figure 6D, on dépose une couche hydrophobe 308 qui sera en contact avec le fluide. Par exemple, cette couche est en SiOC.

Son épaisseur est par exemple comprise entre 10 nm et 100 nm.

Elle est déposée par un procédé conventionnel de dépôt sous vide de type PECVD.

L'énergie de surface de cette couche, plus particulièrement sa composante polaire, est modulée sous l'effet d'un champ électrique imposé par les électrodes formées dans la couche conductrice 304, ce qui permet de faire basculer sa propriété de mouillage à l'eau du domaine hydrophobe au domaine hydrophile.

La couche 306 telle que décrite ci-dessus permet de générer, à faible tension sur la couche métallique 304, inférieure à 40 V, un champ électrique suffisant en surface pour moduler l'énergie de surface de la couche hydrophobe 308.

Après le dépôt de la couche hydrophobe, on peut modifier localement la surface de la couche hydrophobe pour la rendre hydrophile, par exemple pour réaliser des lignes hydrophiles telles que décrites dans le deuxième exemple du premier mode de réalisation.

Pour cela, on réalise une oxydation localisée de la couche hydrophobe, par exemple, en utilisant l'écriture laser ou UV sous atmosphère contenant de l'oxygène, rendant localement la couche hydrophobe hydrophile.

Ces zones oxydées ne peuvent pas changer de mouillabilité et forment des barrières à la génération de germes de vapeur et à la propagation de lignes de vapeur.

Avantageusement, on peut effectuer une structuration à la surface de la seconde couche isolante 306 préalablement au dépôt de la couche hydrophobe 308 afin d'accentuer les propriétés hydrophile et hydrophobe, afin d'atteindre des propriétés de super-hydrophilie et super-hydrophobie.

Cette structuration a pour effet d'augmenter la dynamique d'électromouillage.

La structure peut être réalisée, par exemple, par lithographie par nano-billes de silices de diamètre compris ente 0,5 $\mu$m et 5 $\mu$m et gravure de la seconde couche isolante 306 au travers de ce masque de billes par un plasma fluoré afin d'obtenir un rapport de forme d'au moins 2 : 1 (le rapport de forme est le rapport profondeur sur largeur).

Le tapis de billes est déposé en monocouche par exemple par un procédé de Langmuir-Blodgett.

La gravure plasma induit une réduction progressive de la taille de bille simultanément à la gravure verticale de la couche sous-jacente.

Cet effet peut induire une pente de gravure désirable car elle réduit la fraction de surface supérieure ce qui favorise l'effet « tapis de clous » de la super-hydrophobie ou super-hydrophilie.

Les billes sont ensuite retirées par ultra-sons.

La présente invention s'applique principalement à la réalisation d'échangeurs thermiques diphasiques, de thermosiphons diphasiques et de caloducs.

## Revendications

1. Procédé pour réaliser des échanges thermiques par ébullition d'un liquide polaire sur une surface présentant au moins une zone peu mouillante, consistant à :

   a) générer l'apparition de germes de vapeur sur ladite zone peu mouillante et faire croître lesdits germes,

   b) rendre ladite surface mouillante par au moins un système d'électromouillage comportant au moins une électrode associée à une contre-électrode pour favoriser le détachement des dites bulles de gaz ainsi formées.

2. Procédé pour réaliser des échanges thermiques par ébullition selon la revendication 1, dans lequel la surface est entièrement peu mouillante, et une pluralité de systèmes d'électromouillage est répartie sous cette surface, lors de l'étape b), les systèmes d'électromouillage sont tous activés simultanément pour favoriser le détachement des dites bulles de gaz formées.

3. Procédé pour réaliser des échanges thermiques par ébullition selon la revendication 1, la surface comportant plusieurs systèmes d'électromouillage au nombre de m répartis sous la surface et étant activables séparément, m étant égal à n + p, m, n et p étant des entiers naturels, les étapes a) et b) s'appliquant périodiquement aux n et aux p systèmes d'électromouillage, l'étape a) s'appliquant à n systèmes et l'étape b) à p systèmes simultanément, et l'étape a) s'appliquant simultanément aux p systèmes et l'étape b) au n systèmes simultanément.

4. Procédé pour réaliser des échanges thermiques selon la revendication 3, dans lequel la période d'activation des électrodes est sensiblement égale à la somme de la période de génération des germes de vapeur et de la période de croissance des bulles de vapeur, par exemple comprise entre 10 Hz et 100 Hz.

5. Procédé pour réaliser des échanges thermiques par ébullition selon la revendication 1, dans lequel le système comporte une électrode sous forme d'une piste courant sous la surface, ladite surface comportant au dessus de l'électrode une alternance de zones peu mouillantes et de zones mouillantes, les étapes a) et b) s'appliquant à l'électrode unique.

6. Procédé pour réaliser des échanges thermiques par ébullition selon la revendication 1, ladite ébullition étant convective et confinée, la surface formant une portion d'un conduit dans lequel s'écoule le liquide polaire, ladite surface étant localisée en amont de la zone où à lieu l'échange thermique, la surface comporte des moyens de chauffage, lors de l'étape a), un apport de chaleur est effectué au liquide polaire au niveau de la surface.

7. Dispositif d'échange thermique par ébullition comportant une surface en contact avec un liquide polaire et destinée à extraire de la chaleur d'un élément (T), ladite surface comportant au moins un système apte à modifier localement la mouillabilité de la surface en contact avec le liquide polaire par électromouillage, ledit système comportant au moins une électrode associée à une contre-électrode et des moyens de commande configurés pour activer une électrode par application d'un potentiel à ladite électrode, la surface de la paroi ayant, au moins partiellement, en l'absence de potentiel appliqué à ladite électrode des propriétés de faible mouillabilité, ledit système étant isolé du liquide par une couche diélectrique, de sorte qu'en l'absence de potentiel appliqué par ses moyens de commande, il y ait apparition de germes de bulles de vapeur et croissances desdits germes, et, lors de l'application d'un potentiel par ses moyens de commande il y ait détachement des dites bulles de gaz ainsi formées.

8. Dispositif d'échange thermique selon la revendication 7, dans lequel le liquide polaire s'écoule, ledit système d'électromouillage étant situé dans une partie (202.1) de la paroi en amont de la partie en contact avec l'élément à refroidir, ledit dispositif comportant également des moyens pour faire circuler le liquide dans le conduit et des moyens de chauffage (214) situés au niveau du système d'électromouillage.

9. Dispositif d'échange thermique selon la revendication précédente, dans lequel le système d'électromouillage comporte au moins une électrode (208) associée à une contre-électrode (210) réparties transversalement par rapport à l'écoulement du liquide (4).

10. Dispositif d'échange thermique selon la revendication 9, dans lequel la au moins une électrode (208) a une forme d'anneau et la contre-électrode (210) est située au centre dudit anneau.

11. Dispositif d'échange thermique selon l'une des revendications 8 à 10, dans lequel les moyens de chauffage (214) sont formés par une résistance électrique en forme d'anneau entourée par l'électrode (208) et entourant la contre-électrode (210).

12. Dispositif d'échange thermique selon la revendication 8, dans lequel ledit système d'électromouillage comporte une électrode (508) sous forme de peigne comportant un corps et des doigts transversaux au corps, lesdits doigts étant orientés sensiblement dans la direction d'écoulement du liquide polaire, et une contre-électrode (510) en forme de peigne, les doigts de la contre-électrode étant interdigités avec ceux de l'électrode, la surface comportant également des zones mouillantes (512.1) alternant avec des zones peu mouillantes (512.2) le long des doigts, les moyens de chauffage (514) cheminant entre les doigts de l'électrode (508) et ceux de la contre-électrode (510).

13. Dispositif d'échange thermique selon la revendication 12, dans laquelle les zones mouillantes (512.1) et les zones peu mouillantes (512.2) sont sous forme de bandes sensiblement perpendiculaires à la direction d'écoulement du liquide polaire et s'étendent sur toute la longueur du peigne.

14. Dispositif d'échange thermique selon la revendication 7, dans lequel l'ébullition est en vase, ladite surface formant le fond dudit dispositif, le système d'électromouillage comportant une pluralité d'électrodes (8) associées à au moins une contre-électrode (10), lesdites électrodes étant réparties sur toute la surface de la paroi.

15. Dispositif d'échange thermique selon la revendication 14, dans lequel les moyens de commande activent et désactivent simultanément toutes les électrodes périodiquement.

16. Dispositif d'échange thermique selon la revendication 14, dans lequel les moyens de commande activent et désactivent les électrodes par groupe ou séparément périodiquement de manière déphasée.

17. Dispositif d'échange thermique selon l'une des revendications 14 à 16, dans lequel les électrodes (8) sont réparties en damier.

18. Dispositif d'échange thermique selon la revendication 17, dans lequel toute la surface est peu mouillante.

19. Dispositif d'échange thermique selon la revendication 17, dans lequel les zones (Z1) au dessus des électrodes (8) sont peu mouillantes et les zones (Z2) entre les zones (Z1) au dessus des électrodes (8) sont mouillantes.

20. Dispositif d'échange thermique selon la revendication 19, dans lequel les zones mouillantes (Z2) ont la forme d'un quadrillage.

21. Dispositif d'échange thermique selon la revendication 7, dans lequel l'ébullition est en vase, ladite surface formant le fond dudit dispositif, le système d'électromouillage comportant une électrode (108, 408) sous forme de piste courant sous la surface de la paroi, et une contre-électrode (110, 410) sous forme de piste cheminant à côté de l'électrode (108, 408).

22. Dispositif d'échange thermique selon la revendication 21, dans lequel les surfaces au dessus des pistes sont divisées en zone de faible mouillabilité (118, 412.2) par des zones de bonne mouillabilité (116, 412.1).

23. Dispositif d'échange thermique selon la revendication 21 ou 22, dans lequel l'électrode (108) et la contre-électrode (110) sont configurées sous forme de spirale.

**24.** Dispositif d'échange thermique selon la revendication 23, dans lequel la surface au dessus des électrodes comportent des premières bandes (116) offrant des propriétés de bonne mouillabilité et des deuxièmes bandes (118) offrant des propriétés de faible mouillabilité, lesdites premières et deuxièmes bandes (116, 118) étant alternées et croisant les différentes portions de l'électrode (108).

**25.** Dispositif d'échange thermique selon la revendication 21, dans lequel l'électrode (408) et la contre-électrode (410) ont la forme de peignes interdigités, la surface comportant des zones mouillantes (414.1) et des zones peu mouillantes (414.2) au dessus de l'électrode (408).

**26.** Dispositif d'échange thermique selon la revendication 25, dans lequel les zones mouillantes (414.1) et peu mouillantes (414.2) sont formées par des bandes mouillantes et peu mouillantes croisant les doigts des peignes.

**27.** Dispositif d'échange thermique selon l'une des revendications 7 à 26, dans lequel le liquide polaire est l'eau ou un éthylène glycol.

**28.** Procédé de réalisation d'un dispositif d'échange thermique selon l'une des revendications 7 à 27, comportant les étapes :

a) dépôt d'une première couche isolante électrique (302) sur un substrat (300),
b) dépôt d'une couche conductrice électrique (304) sur ladite couche isolante électrique (302) pour former des électrodes,
c) dépôt d'une deuxième couche isolante électrique (306) sur la couche conductrice électrique (304),
d) dépôt sur la deuxième couche isolante électrique (306) d'un film offrant des propriétés de faible mouillabilité (308).

**29.** Procédé de réalisation d'un dispositif d'échange thermique selon la revendication 28, comportant l'étape ultérieure e) de réalisation dans le film de zones ayant de propriétés de bonne mouillabilité et dans lequel l'étape e) est obtenue par oxydation du film offrant des propriétés de faible mouillabilité (308) au moyen d'un laser.

**30.** Procédé de réalisation d'un dispositif d'échange thermique selon la revendication 28 ou 29, comportant l'étape de gravure de la couche conductrice électrique (304).

**31.** Procédé de réalisation d'un dispositif d'échange thermique selon l'une des revendications 28 à 30, dans lequel le substrat (300) est en acier, le première couche isolante électrique (302) est en SiC/SiO$_2$, et dans lequel la couche de faible mouillabilité (308) est en SiOC.

**Patentansprüche**

**1.** Verfahren zur Realisierung eines Wärmeaustauschs durch Sieden einer polaren Flüssigkeit auf einer Oberfläche, welche mindestens eine mäßig benetzende Zone aufweist, wobei das Verfahren die folgenden Schritte umfasst:

a) das Auftreten von Dampfkeimen auf der besagten mäßig benetzenden Zone zu erzeugen und die besagten Keime zu wachsen zu lassen;
b) die besagte Oberfläche durch zumindest ein Elektro-Benetzungssystem benetzend zu machen, wobei das Elektro-Benetzungssystem mindestens eine mit einer Gegenelektrode verbundene Elektrode aufweist, um das Loslösen der auf diese Weise gebildeten Gasblasen zu fördern.

**2.** Verfahren zur Realisierung eines Wärmeaustauschs durch Sieden nach Anspruch 1, in welchem die ganze Oberfläche mäßig benetzend ist, und wobei eine Vielzahl an Elektro-Benetzungssystemen unter dieser Oberfläche verteilt ist, wobei während dem Schritt b) die Elektro-Benetzungssysteme alle gleichzeitig aktiviert werden, um das Loslösen der besagten gebildeten Gasblasen zu fördern.

**3.** Verfahren zur Realisierung eines Wärmeaustauschs durch Sieden nach Anspruch 1, wobei die Oberfläche mehrere Elektro-Benetzungssysteme in derAnzahl m umfasst, welche unter der Oberfläche verteilt sind und getrennt voneinander aktivierbar sind, wobei m gleich n+p ist, wobei m, n und p natürliche Zahlen sind, wobei die Schritte a) und b) periodisch bei n und bei p Elektro-Benetzungssystemen Anwendung finden, wobei der Schritt a) bei n Systemen und der Schritt b) bei p Systemen gleichzeitig Anwendung findet, und der Schritt a) gleichzeitig bei p Systemen und der Schritt b) gleichzeitig bei n Systemen Anwendung findet.

**4.** Verfahren zur Realisierung eines Wärmeaustauschs nach Anspruch 3, in welchem der Elektroden-Aktivierungszeitraum im Wesentlichen gleich der Summe des Erzeugungszeitraums der Dampfkeime und des Wachzeitraums der Dampfblasen ist, beispielsweise zwischen 10Hz und 100Hz liegt.

**5.** Verfahren zur Realisierung eines Wärmeaustauschs durch Sieden nach Anspruch 1, in welchem das System eine Elektrode in Form einer unter der Oberfläche verlaufenden Spur umfasst, wobei die besagte Oberfläche auf der Elektrode ein Wechselspiel von mäßig benetzenden und benetzenden Zonen aufweist, wobei die Schritte a) und b) bei der einzigen Elektrode Anwendung finden.

6. Verfahren zur Realisierung eines Wärmeaustauschs durch Sieden nach Anspruch 1, wobei der besagte Siedevorgang konvektiv und abgegrenzt ist, wobei die Oberfläche einen Leitungsabschnitt bildet, in welchem die polare Flüssigkeit fließt, wobei die besagte Oberfläche vor der Zone angeordnet ist, wo der Wärmeaustausch stattfindet, wobei die Oberfläche Heizeinrichtungen umfasst, mit denen während Schritt a) der polaren Flüssigkeit an der Oberfläche Wärme zugeführt wird.

7. Vorrichtung zum Wärmeaustausch durch Sieden, welche eine Oberfläche in Kontakt mit einer polaren Flüssigkeit umfasst, und welche dazu bestimmt ist, Wärme aus einem Element (T) zu gewinnen, wobei die besagte Oberfläche mindestens ein System aufweist, welches in der Lage ist, die Benetzbarkeit der Oberfläche, welche in Kontakt mit der polaren Flüssigkeit ist, durch Elektro-Benetzung lokal zu verändern, wobei das System mindestens eine mit einer Gegenelektrode verbundene Elektrode sowie Steuereinrichtungen umfasst, welche zur Aktivierung einer Elektrode durch Anlegung eines Potentials an die besagte Elektrode konfiguriert sind, wobei die Oberfläche der Wand zumindest teilweise in Abwesenheit des an die besagte Elektrode angelegten Potentials Eigenschaften schwacher Benetzbarkeit aufweist, wobei das System durch eine dielektrische Schicht von der Flüssigkeit isoliert ist, so dass in Abwesenheit des Potentials, welches durch die Steuereinrichtungen angelegt wird, das Auftreten von Dampfblasenkeimen und ein Wachsen dieser Keime erfolgt, und während der Anlegung eines Potentials durch die Steuereinrichtungen eine Loslösung der auf diese Weise gebildeten Gasblasen erfolgt.

8. Vorrichtung zum Wärmeaustausch nach Anspruch 7, in welcher die polare Flüssigkeit fließt, wobei das Elektro-Benetzungssystem in einem Abschnitt (202.1) der Wand vor dem Abschnitt angeordnet ist, welcher in Kontakt mit dem abzukühlenden Element ist, wobei die besagte Vorrichtung darüber hinaus Einrichtungen, welche die Zirkulation der Flüssigkeit in der Leitung bewirken, sowie Heizeinrichtungen (214) aufweist, welche an dem Elektro-Benetzungssystem angeordnet sind.

9. Vorrichtung zum Wärmeaustausch nach dem vorhergehenden Anspruch, in welcher das Elektro-Benetzungssystem mindestens eine Elektrode (208) aufweist, welche mit einer Gegenelektrode (210) verbunden ist, wobei die Elektroden quer im Verhältnis zur Strömung der Flüssigkeit (4) verteilt sind.

10. Vorrichtung zum Wärmeaustausch nach Anspruch 9, in welcher die mindestens eine Elektrode (208) die Form eines Rings aufweist, und in welcher die Gegenelektrode (210) in der Mitte dieses Rings angeordnet ist.

11. Vorrichtung zum Wärmeaustausch nach einem der Ansprüche 8 bis 10, in welcher die Heizeinrichtungen (214) durch einen elektrischen Widerstand in Form eines Rings gebildet sind, welcher von der Elektrode (208) umgeben ist und die Gegenelektrode (210) umgibt.

12. Vorrichtung zum Wärmeaustausch nach Anspruch 8, in welcher das Elektro-Benetzungssystem eine Elektrode (508) in Form eines Kamms aufweist, welcher ein Hauptstück und quer zum Hauptstück angeordnete Finger umfasst, wobei die Finger im Wesentlichen in die Strömungsrichtung der polaren Flüssigkeit ausgerichtet sind, sowie eine Gegenelektrode (510) in Form eines Kamms umfasst, wobei die Finger der Gegenelektrode in interdigitaler Anordnung mit denen der Elektrode vorliegen, wobei die Oberfläche darüber hinaus benetzende Zonen (512.1) aufweist, welche sich mit den mäßig benetzenden Zonen (512.2) entlang der Finger abwechseln, wobei die Heizeinrichtungen (514) zwischen den Fingern der Elektrode (508) und denen der Gegenelektrode (510) verlaufen.

13. Vorrichtung zum Wärmeaustausch nach Anspruch 12, in welcher die benetzenden Zonen (512.1) sowie die mäßig benetzenden Zonen (512.2) die Form von Streifen haben, welche im Wesentlichen senkrecht zur Strömungsrichtung der polaren Flüssigkeit sind und sich über die gesamte Länge des Kamms erstrecken.

14. Vorrichtung zum Wärmeaustausch nach Anspruch 7, in welcher der Siedevorgang abgeschlossen stattfindet, wobei die besagte Oberfläche den Boden der Vorrichtung bildet, wobei das Elektro-Benetzungssystem eine Vielzahl von Elektroden (8) aufweist, welche mit mindestens einer Gegenelektrode (10) verbunden sind, wobei die besagten Elektroden auf der gesamten Oberfläche der Wand verteilt sind.

15. Vorrichtung zum Wärmeaustausch nach Anspruch 14, in welcher die Steuereinrichtungen gleichzeitig alle Elektroden periodisch aktivieren und deaktivieren.

16. Vorrichtung zum Wärmeaustausch nach Anspruch 14, in welcher die Steuereinrichtungen die Elektroden gruppenweise oder einzeln periodisch phasenverschoben aktivieren und deaktivieren.

17. Vorrichtung zum Wärmeaustausch nach einem der Ansprüche 14 bis 16, in welcher die Elektroden (8) schachbrettartig verteilt sind.

18. Vorrichtung zum Wärmeaustausch nach Anspruch 17, in welcher die gesamte Oberfläche mäßig benetzend ist.

19. Vorrichtung zum Wärmeaustausch nach Anspruch 17, in welcher die Zonen (Z1) über den Elektroden (8) mäßig benetzend sind und die Zonen (Z2) zwischen den Zonen (Z1) über den Elektroden (8) benetzend sind.

20. Vorrichtung zum Wärmeaustausch nach Anspruch 19, in welcher die benetzenden Zonen (Z2) die Form eines Rasters haben.

21. Vorrichtung zum Wärmeaustausch nach Anspruch 7, in welcher der Siedevorgang abgeschlossen stattfindet, wobei die Oberfläche den Boden der Vorrichtung bildet, wobei das Elektro-Benetzungssystem eine Elektrode (108, 408) in Form einer Spur, welche unter der Oberfläche der Wand verläuft, sowie eine Gegenelektrode (110, 410) in Form einer Spur umfasst, welche an der Seite der Elektrode (108, 408) verläuft.

22. Vorrichtung zum Wärmeaustausch nach Anspruch 21, in welcher die Oberflächen über den Spuren in eine Zone schwacher Benetzbarkeit (118, 412.2) und eine Zone guter Benetzbarkeit (116, 412.1) unterteilt sind.

23. Vorrichtung zum Wärmeaustausch nach Anspruch 21 oder 22, in welcher die Elektrode (108) und die Gegenelektrode (110) spiralförmig konfiguriert sind.

24. Vorrichtung zum Wärmeaustausch nach Anspruch 23, in welcher die Oberfläche über den Elektroden erste Streifen (116) umfasst, welche Eigenschaften guter Benetzbarkeit aufweisen, sowie zweite Streifen (118), welche Eigenschaften schwacher Benetzbarkeit aufweisen, wobei sich die ersten und zweiten Streifen (116, 118) abwechseln und die unterschiedlichen Abschnitte der Elektrode (108) kreuzen.

25. Vorrichtung zum Wärmeaustausch nach Anspruch 21, in welcher die Elektrode (408) und die Gegenelektrode (410) die Form ineinandergreifender Kämme aufweisen, wobei die Oberfläche benetzende Zonen (414.1) und mäßig benetzende Zonen (412.2) über der Elektrode (408) aufweisen.

26. Vorrichtung zum Wärmeaustausch nach Anspruch 25, in welcher die benetzenden Zonen (414.1) und die mäßig benetzenden Zonen (414.2) durch benetzende und mäßig benetzende Streifen gebildet sind, welche die Finger der Kämme kreuzen.

27. Vorrichtung zum Wärmeaustausch nach einem der Ansprüche 7 bis 26, bei welcher es sich bei der polaren Flüssigkeit um Wasser oder Ethylenglykol handelt.

28. Verfahren zur Realisierung einer Vorrichtung zum Wärmeaustausch nach einem der Ansprüche 7 bis 27, wobei das Verfahren die folgenden Schritte umfasst:

a) Aufbringen einer ersten elektrischen Isolierschicht (302) auf ein Substrat (300);
b) Aufbringen einer elektrisch leitenden Schicht (304) auf die besagte elektrische Isolierschicht (302), um die Elektroden zu bilden;
c) Aufbringen einer zweiten elektrischen Isolierschicht (306) auf die elektrisch leitende Schicht (304);
d) Aufbringen eines Films (308), welcher Eigenschaften schwacher Benetzbarkeit aufweist, auf die zweite elektrische Isolierschicht (306).

29. Verfahren zur Realisierung einer Vorrichtung zum Wärmeaustausch nach Anspruch 28, wobei das Verfahren den weiteren Schritt e) der Realisierung von Zonen in dem Film aufweist, welche Eigenschaften guter Benetzbarkeit aufweisen, und bei welchem der Schritt e) durch Oxidation des Films (308), welcher Eigenschaften schwacher Benetzbarkeit (308) aufweist, mit Hilfe eines Lasers erreicht wird.

30. Verfahren zur Realisierung einer Vorrichtung zum Wärmeaustausch nach Anspruch 28 oder 29, wobei das Verfahren den Schritt des Ätzens der elektrischen leitenden Schicht (304) umfasst.

31. Verfahren zur Realisierung einer Vorrichtung zum Wärmeaustausch nach einem der Ansprüche 28 bis 30, in welcher das Substrat (300) aus Stahl ist, die erste elektrische Isolierschicht (302) aus $SiC/SiO_2$ ist, und in welcher die Schicht (308) mit schwacher Benetzbarkeit aus SiOC ist.

## Claims

1. A method to implement heat exchanges by boiling a polar liquid on a surface having at least one low-wetting zone, consisting in:

a) generating the appearance of nuclei of vapour bubbles on said low-wetting zone, and causing said nuclei to grow,
b) making said surface wetting by at least one electro-wetting system comprising at least one electrode associated with a counter electrode to favour the detachment of said gas bubbles formed in this manner.

**2.** A method to implement heat exchanges by boiling according to claim 1, in which the surface is entirely low-wetting, and multiple electro-wetting systems are distributed under this surface; in step b) the electro-wetting systems are all activated simultaneously to favour detachment of said gas bubbles formed.

**3.** A method to implement heat exchanges by boiling according to claim 1, wherein the surface comprises a number m of electro-wetting systems, distributed under the surface and able to be activated separately, wherein m is equal to n + p, wherein m, n and p are natural integers, wherein steps a) and b) are applied periodically to the n and to the p electro-wetting systems, wherein step a) is applied to n systems and step b) to p systems simultaneously, and wherein step a) is applied simultaneously to the p systems and step b) to the n systems simultaneously.

**4.** A method to implement heat exchanges according to claim 3, in which the period of activation of the electrodes is roughly equal to the sum of the period of generation of the nuclei of vapour bubbles and of the growth period of the vapour bubbles, for example between 10 Hz and 100 Hz.

**5.** A method to implement heat exchanges by boiling according to claim 1, in which the system comprises an electrode in the form of a track running under the surface, wherein said surface has, above the electrode, alternating low-wetting and wetting zones, and wherein steps a) and b) apply to the single electrode.

**6.** A method to implement heat exchanges by boiling according to claim 1, wherein said boiling is convective and confined, and the surface then forms a portion of a duct in which the polar liquid flows, wherein said surface is located upstream from the zone wherein the heat exchange takes place; the surface comprises heating means; during step a), the polar liquid undergoes a heat transfer on the surface.

**7.** A device for heat exchange by boiling comprising a surface in contact with a polar liquid and intended to extract heat from an element (T), wherein said surface comprises at least one system able to modify locally the wettability of the surface in contact with the polar liquid by electro-wetting, wherein said system comprises at least one electrode associated with a counter electrode and control means configured to activate an electrode by application of a potential to said electrode, wherein the wall of the surface has, at least partially, if no potential is applied to said electrode by the control means, low wettability properties, and wherein the system is insulated from the liquid by a dielectric layer, such that if there is no potential nuclei of vapour bubbles and growth of said nuclei appear and, when a potential is applied by the control means, said gas bubbles formed in this manner become detached.

**8.** A heat exchange device according to claim 7, in which the polar liquid flows, wherein said electro-wetting system is located in a portion (202.1) of the wall upstream from the portion in contact with the element to be cooled, and wherein said device also comprises means to cause the liquid to flow in the duct, and heating means (214) located in the area of the electro-wetting system.

**9.** A heat exchange device according to the previous claim, in which the electro-wetting system comprises at least one electrode (208) associated with a counter electrode (210) distributed transversely relative to the direction of flow of the liquid (4).

**10.** A heat exchange device according to claim 9, in which at least one electrode (208) has the shape of a ring, and the counter electrode (210) is positioned in the centre of said ring.

**11.** A heat exchange device according to one of the claims 8 to 10, in which the heating means (214) are formed by a ring-shaped electrical resistor surrounded by the electrode (208) and surrounding the counter electrode (210).

**12.** A heat exchange device according to claim 8, in which said electro-wetting system comprises a comb-shaped electrode (508) comprising a body and fingers transverse to the body, wherein said fingers are aligned roughly in the polar liquid's direction of flow, and a comb-shaped counter electrode (510), wherein the fingers of the counter electrode are interdigitated with those of the electrode, wherein the surface also comprises wetting zones (512.1) alternating with low-wetting zones (512.2) along the fingers, and wherein the heating means (514) pass between the fingers of the electrode (508) and those of the counter electrode (510).

**13.** A heat exchange device according to claim 12, in which the wetting zones (512.1) and the low-wetting zones (512.2) take the form of strips roughly perpendicular to the direction of flow of the polar liquid, and extend along the full length of the comb.

**14.** A heat exchange device according to claim 7, in which the boiling takes place in a vessel, wherein said surface forms the base of said device, wherein the electro-wetting system comprises multiple electrodes (8) associated with at least one counter electrode (10), and wherein said electrodes are distributed over the entire surface of the wall.

**15.** A heat exchange device according to claim 14, in which the control means simultaneously activate and deactivate all the electrodes periodically.

16. A heat exchange device according to claim 14, in which the control means activate and deactivate the electrodes in groups or separately and periodically in a phase-shifted manner.

17. A heat exchange device according to one of the claims 14 to 16, in which the electrodes (8) are distributed as on a draughtsboard.

18. A heat exchange device according to claim 17, in which the entire surface is low-wetting.

19. A heat exchange device according to claim 17, in which the zones (Z1) above the electrodes (8) are low-wetting and the zones (Z2) between the zones (Z1) above the electrodes (8) are wetting.

20. A heat exchange device according to claim 19, in which the wetting zones (Z2) take the form of a grid.

21. A heat exchange device according to claim 7, in which boiling takes place in a vessel, wherein said surface forms the base of said device, wherein the electro-wetting system comprises an electrode (108, 408) in the form of a track running under the surface of the wall, and a counter electrode (110, 410) in the form of a track passes beside the electrode (108, 408).

22. A heat exchange device according to claim 21, in which the surfaces above the tracks are divided into zones of low wettability (118, 412.2) by zones of satisfactory wettability (116, 412.1).

23. A heat exchange device according to claim 21 or 22, in which the electrode (108) and the counter electrode (110) are configured in the form of a spiral.

24. A heat exchange device according to claim 22, in which the surface above the electrodes comprises first strips (116) having properties of satisfactory wettability, and second strips (118) having properties of low wettability, wherein said first and second strips (116, 118) alternate and intersect the various portions of the electrode (108).

25. A heat exchange device according to claim 21, in which the electrode (408) and the counter electrode (410) take the form of interdigitated combs, wherein the surface has wetting zones (414.1) and low-wetting zones (414.2) above the electrode (408).

26. A heat exchange device according to the previous claim, in which the wetting zones (414.1) and low-wetting zones (414.2) are formed by wetting and low-wetting strips intersecting the combs' fingers.

27. A heat exchange device according to one of the claims 7 to 26, in which the polar liquid is water or an ethylene glycol.

28. A method for production of a thermal exchange device according to one of the claims 7 to 27, comprising the following steps:

a) deposition of a first electrical insulating layer (302) on a substrate (300),
b) deposition of an electrical conducting layer (304) on said electrical insulating layer (302) to form electrodes,
c) deposition of a second electrical insulating layer (306) on the electrical conducting layer (304),
d) deposition on the second electrical insulating layer (306) of a film having low wettability properties (308).

29. A method of production of a heat exchange device according to claim 28, comprising the subsequent step e) of production in the film of zones having satisfactory wettability properties and in which step e) is obtained by oxidisation of the film having low wettability properties (308) by means of a laser.

30. A method of production of a heat exchange device according to one of the claims 30 to 29, comprising the step of etching of the electrical conducting layer (304).

31. A method of production of a heat exchange device according to one of the claims 28 to 30, in which the substrate (300) is made of steel, and the first electrically insulating layer (302) is made of $SiC/SiO_2$, and in which the layer of low wettability (308) is made of SiOC.

FIG.1A

FIG.1B

L : 50 - 500 µm
X : 10 - 50 µm

FIG.2

FIG.3

FIG.4A

FIG.4B

FIG.4C

FIG.5

FIG.6A

302
300

FIG.6B

304
302
300

FIG.6C

306
304
302
300

FIG.6D

308
306
304
302
300

FIG.7A

FIG.7B

FIG.8A

d = 100 nm    d = 1000 nm

FIG.8B

d = 100 nm    d = 1000 nm

**EP 2 478 320 B1**

## RÉFÉRENCES CITÉES DANS LA DESCRIPTION

**Documents brevets cités dans la description**

- US 20080047701 A1